Europäisches Patentamt

European Patent Office

Office européen des brevets

(19)

(11) Numéro de publication: **0 182 414**
**A1**

(12) **DEMANDE DE BREVET EUROPEEN**

(21) Numéro de dépôt: **85201741.7**

(22) Date de dépôt: **28.10.85**

(51) Int. Cl.⁴: **H 03 K 3/356**

(30) Priorité: **09.11.84 FR 8417095**

(43) Date de publication de la demande: **28.05.86**
**Bulletin 86/22**

(84) Etats contractants désignés: **DE FR GB IT NL**

(71) Demandeur: **Laboratoires d'Electronique et de Physique Appliquée L.E.P., 3, Avenue Descartes, F-94450 Limeil-Brévannes (FR)**

(84) Etats contractants désignés: **FR**

(71) Demandeur: **N.V. Philips' Gloeilampenfabrieken, Groenewoudseweg 1, NL-5621 BA Eindhoven (NL)**

(84) Etats contractants désignés: **DE GB IT NL**

(72) Inventeur: **Binet, Michel Joseph-Marie, Société Civile S.P.I.D. 209 rue de l'Université, F-75007 Paris (FR)**
Inventeur: **Ducourant, Thierry, Société Civile S.P.I.D. 209 rue de l'Université, F-75007 Paris (FR)**

(74) Mandataire: **Landousy, Christian et al, Société Civile S.P.I.D. 209, Rue de l'Université, F-75007 Paris (FR)**

(54) **Comparateur synchronisé.**

(57) Le comparateur comprend un étage d'acquisition (1) servant à comparer une tension d'entrée analogique $V_{IN}$ à une tension de référence analogique $V_{REF}$ et à fournir le résultat de la comparaison sous forme d'un signal intermédiaire $V_M$ et de son complémentaire $\overline{V_M}$, un étage amplificateur (2) servant à amplifier les états logiques du signal intermédiaire, un premier et un second étage mémoire (3 et 4) couplés respectivement à l'étage d'acquisition et à l'étage amplificateur, servant à produire et à retenir les états logiques déterminés par les signaux issus des étages d'acquisition et amplificateur, caractérisé en ce qu'il comprend en outre un second étage d'acquisition (5) placé en parallèle sur le premier et servant à compenser l'hystérésis qui y apparaît, et un second étage amplificateur (6) placé en parallèle sur le premier et servant à lever l'indétermination sur la phase des états logiques du signal intermédiaire, en ce que le premier et le second étage mémoire sont mis en fonctionnement alternativement par un premier signal d'horloge C et son complémentaire $\overline{C}$, le premier et le second étage amplificateur sont mis en fonctionnement alternativment par un second signal d'horloge H et son complémentaire $\overline{H}$, et en ce que ces étages amplificateurs travaillent en phase avec les étages d'acquisition et le premier étage mémoire.

Application: convertisseur analogique-numérique réalisé à l'aide de transistors à effet de champ à désertion de charge en arséniure de gallium.

## COMPARATEUR SYNCHRONISE

L'invention concerne un comparateur de tensions synchronisé, réalisé à l'aide de transistors dotés chacun d'une borne de commande, d'une première borne principale et d'une seconde borne principale, ce comparateur comprenant :

- un étage d'acquisition servant à comparer une tension d'entrée analogique à une tension de référence analogique et à fournir le résultat de la comparaison sous forme d'un signal intermédiaire et de son complémentaire, cet étage incluant deux transistors formant une première paire différentiel, la tension d'entrée et la tension de référence étant appliquées respectivement sur les bornes de commande de ces transistors dont les premières bornes principales présentent un point de connexion servant à amener un courant de réglage, et dont les secondes bornes principales sont couplées chacune par l'intermédiaire d'une charge à une première borne d'alimentation continue et fournissent respectivement le signal intermédiaire et son complémentaire ;

- un étage amplificateur servant à amplifier les états logiques du signal intermédiaire, cet étage incluant deux transistors formant une deuxième paire différentielle, ledit signal intermédiaire et son complémentaire étant appliqués respectivement sur les bornes de commande de ces transistors dont les premières bornes principales servent à amener un courant de réglage et dont les secondes bornes principales sont couplées chacune par l'intermédiaire d'une charge à la première borne d'alimentation continue et fournissent le signal numérique de sortie du comparateur, et son complémentaire ;

- un premier et un second étage mémoire couplés respectivement à l'étage d'acquisition et à l'étage amplificateur, servant à produire et à retenir les états logiques déterminés par les signaux issus des étages d'acquisition et amplificateur, le premier de ces étages mémoires incluant deux transistors formant une troisième paire différentielle montée en bascule bistable, le signal intermédiaire et son complémentaire étant appliqués respectivement sur les bornes de commande de ces transistors dont les premières bornes principales présentent un point de connexion servant à amener un courant de réglage et dont les secondes bornes principales sont couplées en croix aux secondes bornes principales des transistors de l'étage d'acquisition, le second de ces étages mémoires incluant deux transistors formant une quatrième paire différentielle montée en bascule bistable, le signal intermédiaire et son complémentaire étant appliqués respectivement sur les bornes de commande de ces transistors, dont les premières bornes principales présentent un point de connexion servant à amener un courant de réglage et dont les secondes bornes principales sont couplées en croix aux secondes bornes principales des transistors de l'étage amplificateur.

Un tel circuit peut être appliqué entre autres à un convertisseur analogique-numérique dit parallèle dans lequel le signal d'entrée analogique est amené aux entrées de plusieurs circuits comparateurs parallèles pour obtenir un signal de sortie numérique, circuits dans lesquels cette tension d'entrée est comparée avec une tension de référence qui est différente pour chaque circuit comparateur. Les signaux de sortie des circuits comparateurs sont convertis en un signal de sortie numérique à l'aide d'un dispositif de décodage. Le comparateur synchronisé utilisé dans de tels comparateurs analogiques parallèles présente en général une structure comme décrite dans le préambule.

Un tel circuit est connu entre autres du brevet des Etats-Unis d'Amérique N° 4.121.120. Ce circuit connu, constitué de transistors bipolaires, comprend un étage d'acquisition formé d'une première paire de transistors couplés par leur émetteur et dont les bases reçoivent les signaux d'entrée. Ce circuit comprend ensuite un étage amplificateur formé d'une seconde paire de transistors couplés par leurs émetteurs et dont les bases reçoivent les signaux issus des collecteurs des transistors de l'étage d'acquisition. Ce circuit comprend enfin deux étages mémoires, formés respectivement d'une troisième et d'une quatrième paire de transistors couplés par leurs émetteurs, et dont les collecteurs sont couplés en croix respectivement d'une part aux collecteurs de la première paire de transistors, et d'autre part aux collecteurs de la deuxième paire de transistors. De plus, les émetteurs desdites première, deuxième, troisième et quatrième paire de transistors sont couplés chacun à une source de courant à travers un interrupteur formé par un transistor, les interrupteurs du circuit d'acquisition et du premier étage mémoire étant couplés par leurs émetteurs communs à une première source de courant, et les interrupteurs du circuit amplificateur et du second étage mémoire étant couplés par leurs émetteurs communs à une seconde source de courant. Enfin, lesdits interrupteurs sont commandés par des signaux d'horloge de manière à ce que le circuit d'acquisition et le second étage mémoire fonctionnent en même temps, précisément pendant que l'étage amplificateur et le premier étage mémoire ne sont pas en fonctionnement. Ce circuit connu fournit en sortie du premier étage mémoire un signal intermédiaire dont les états logiques suivent le signe de la différence entre le signal d'entrée et le signal de référence appliqués à l'entrée de l'étage d'acquisition, cette différence étant acquise sur le front de montée du signal d'horloge. L'étage amplificateur fournit en sortie du comparateur un signal numérique amplifié dont les états logiques suivent les états du signal intermédiaire, sont acquis sur un front de montée de l'horloge et sont maintenus par le second étage mémoire jusqu'à ce qu'un autre état apparaisse sur un front de montée.

Mais dans le but de réaliser de nouveaux systèmes logiques permettant des débits d'information toujours plus grands, de tels circuits doivent être transposés dans de nouvelles technologies comme par exemple une technologie incluant des transistors à effet de champ en arséniure de gallium.

En effet, dans le cas où par exemple un transistor à effet de champ à désertion de charge en arséniure de gallium est choisi comme élément actif d'un comparateur synchronisé, on peut s'attendre à une très grande vitesse de fonctionnement sans pour autant être pénalisé par une trop forte puissance consommée.

Mais en revanche ce transistor présente un phénomène d'hystérésis.

Ce phénomène se traduit par les faits suivants : si on applique une tension grille sur un transistor et si l'on fait varier la tension drain entre deux valeurs, alors on constate que les transitoires de courant ne sont pas carrées (alors que la modulation est carrée) et qu'il s'introduit des constantes de l'ordre d'une centaine de millisecondes et même davantage.

Cela se traduit dans le comparateur par de l'hystérésis : avec une tension de référence fixe continue, si l'on augmente progressivement la tension d'entrée, on aura basculement pour une tension d'entrée supérieure à la tension de référence. Par contre, si l'on diminue la tension d'entrée, on obtient le basculement pour une tension inférieure à la tension de référence.

C'est pourquoi la présente invention vise à fournir un comparateur synchronisé, réalisable dans une telle technologie incluant des transistors à désertion de charges en arséniure de gallium, mais dont les effets dûs à l'hystérésis des transistors soient annulés du fait de la structure particulière du comparateur et ceci, sans qu'un défaut d'indétermination de phase n'apparaisse.

Selon la présente invention ce but est atteint à l'aide d'un comparateur tel que décrit dans le préambule caractérisé en ce qu'il comprend en outre :

- un second étage d'acquisition servant à compenser l'hystérésis du premier étage d'acquisition, ce second étage d'acquisition incluant deux transistors formant une cinquième paire différentielle, la tension d'entrée et la tension de référence étant appliquées respectivement sur les bornes de commande de ces transistors dont les premières bornes principales présentent un point de connexion servant à amener un courant de réglage et dont les secondes bornes principales sont couplées en croix aux secondes bornes principales des transistors du premier étage d'acquisition.

- un second étage amplificateur servant à lever l'indétermination sur la phase des états logiques du signal intermédiaire, ce second étage amplificateur incluant deux transistors formant une sixième paire différentielle, ledit signal intermédiaire et son complémentaire étant appliqués respectivement sur les bornes de commande de ces transistors, dont les premières bornes principales servent à amener un courant de réglage et dont les secondes bornes principales sont couplées en croix aux secondes bornes principales des transistors du premier étage amplificateur, et caractérisé en ce que les courants de réglage de la première et de la cinquième paire différentielle sont tels que le premier et le second étage d'acquisition travaillent alternativement, en ce que les courants de réglage de la deuxième et de la sixième paire différentielle sont tels que le premier et le second étage amplificateur travaillent alternativement, en ce que les courants de réglage de la troisième et de la quatrième paire différentielle sont tels que le premier et le second étage mémoire travaillent alternativement, et en ce que les courants de réglage des étages amplificateurs sont tels qu'ils travaillent en phase avec les étages d'acquisition et avec le premier étage mémoire.

Dans ces conditions du fait que les deux étages d'acquisition sont mis en fonctionnement alternativement, l'hystérésis due à un seul étage d'acquisition est compensée.

D'autre part du fait que les étages amplificateurs sont mis en fonctionnement en phase avec les étages d'acquisition et avec le premier étage mémoire, l'inversion de phase qui apparaît dans les étages d'acquisition est également compensée.

Un tel comparateur peut donc être réalisé à l'aide de transistors à effet de champ à désertion de charges en arséniure de gallium ;

L'invention sera mieux comprise à l'aide de la description suivante illustrée par les figures annexées dont :

- la figure 1 qui montre le circuit selon l'invention dans lequel les différents étages sont représentés par des blocs ;

- la figure 2 qui montre l'évolution des signaux dans les différentes parties du circuit, en fonction des signaux d'horloge ;

- la figure 3 qui montre le circuit selon l'invention dans le cas où il est réalisé à l'aide de transistors à effet de champ à désertion de charges en logique BLF ;

- la figure 4 qui montre un circuit convertisseur analogique numérique réalisé à l'aide de comparateurs selon l'invention.

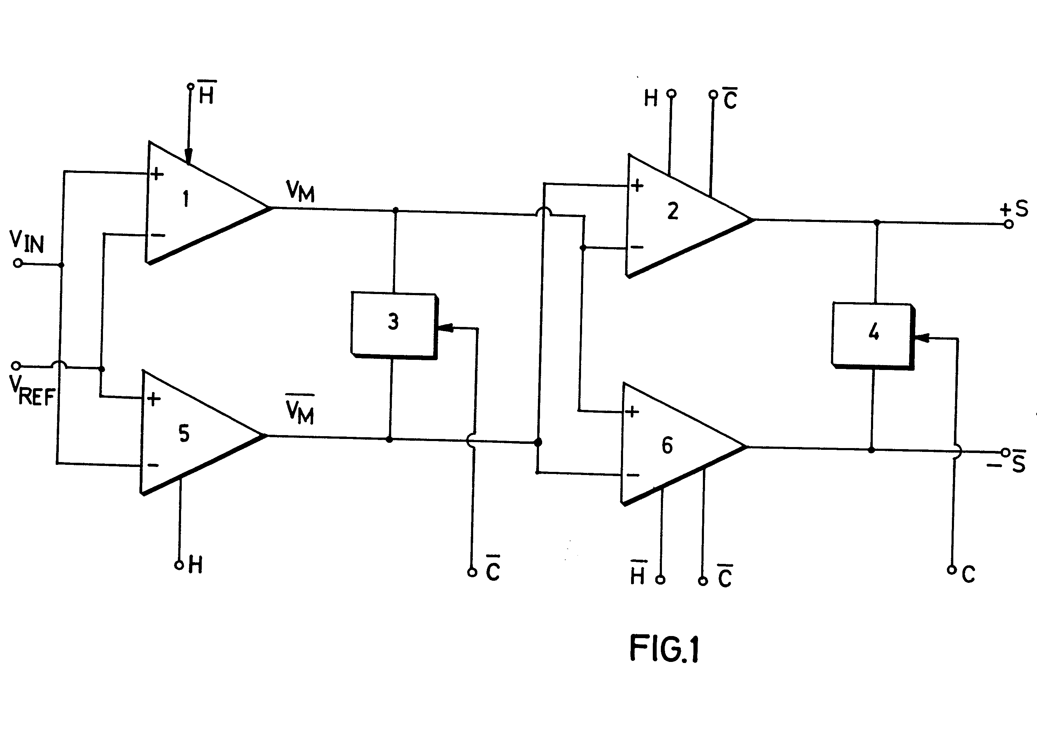

Tel que représenté sur la figure 1, le comparateur synchronisé conforme à l'invention, comprend deux étages d'acquisition 1 et 5 couplés à un premier étage mémoire 3. Chaque étage d'acquisiton reçoit d'une part un signal d'entrée analogique $V_{IN}$ et d'autre part un signal de référence analogique $V_{REF}$ et leurs sorties couplées fournissent un signal intermédiaire $V_M$ et son complémentaire $\overline{V_M}$.

Le comparateur comprend d'autre part deux étages amplificateurs 2 et 6 couplés à un second étage mémoire 4. Chaque amplificateur reçoit les signaux intermédiaires $V_M$ et $\overline{V_M}$, et leurs sorties couplées fournissent un signal numérique amplifié en phase avec la valeur de la différence entre le signal d'entrée $V_{IN}$ et le signal de référence $V_{REF}$.

Le premier et le second étage mémoire 3 et 4, sont mis en fonctionnement alternativement respectivement par le signal d'horloge complémentaire $\overline{C}$ et par le signal d'horloge C.

Le premier et le second étage d'acquistion 1 et 5 sont mis en fonctionnement alternativement respectivement par le complémentaire $\overline{H}$ d'un second signal d'horloge et par le second signal d'horloge H.

Le premier et le second étage amplificateur 2 et 6 sont mis en fonctionnement alternativement, en même temps que le second et le premier étage d'acquisition par les seconds signaux d'horloge H et $\overline{H}$ et en même temps que le premier étage mémoire par le complémentaire $\overline{C}$ du premier signal d'horloge.

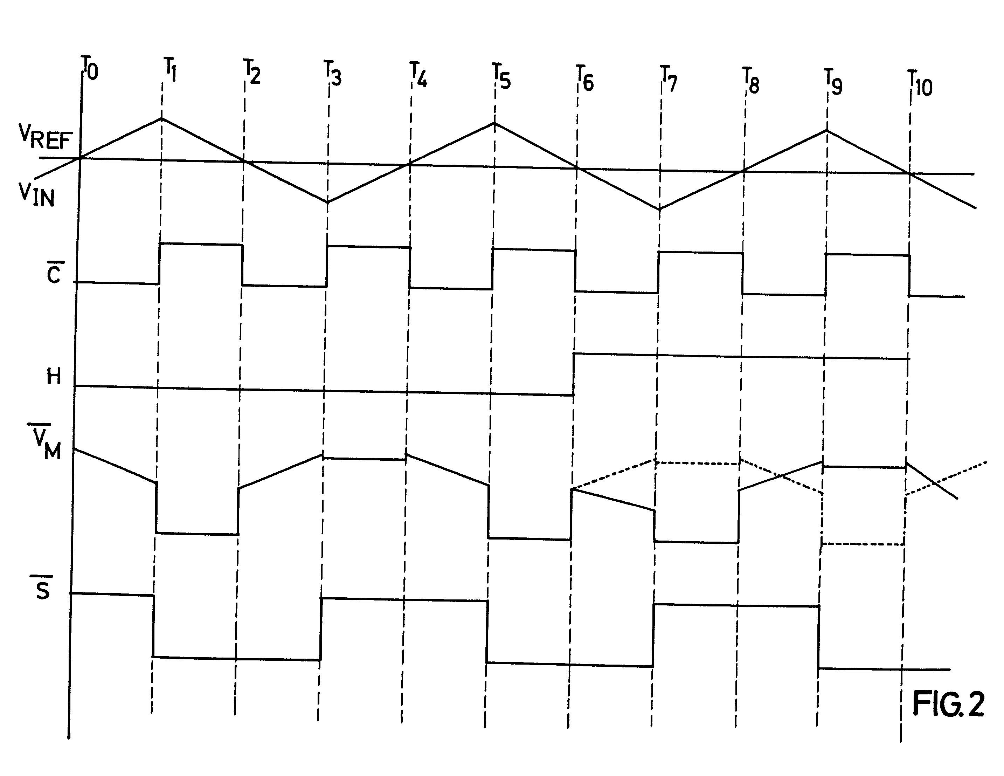

Dans ces conditions, comme il est montré sur la figure 2, lorsque la différence entre le signal d'entrée analogique $V_{IN}$ et le signal de référence analogique $V_{REF}$ appliquée sur le premier étage d'acquisition est positive et qu'arrive le front montant du complémentaire $\overline{C}$ du premier signal d'horloge qui déclenche le premier étage mémoire, le complémentaire $\overline{V_M}$ du signal intermédiaire passe à l'état logique bas. De même, lorsque cette différence est négative, le signal $\overline{V_M}$ passe à l'état logique haut.

Le premier étage amplificateur amplifie les états logiques du signal intermédiaire $V_M$, les maintient pendant la période du premier signal d'horloge C qui commande le second étage mémoire et fournit en sortie un signal numérique binaire $\overline{S}$ qui suit l'inverse du signe de la différence entre les signaux analogiques d'entrée.

Mais périodiquement le second étage d'acquisiton est mis en fonctionnement par l'horloge $\overline{H}$ dans le but d'annuler l'effet d'hystérésis.

La phase correcte du signal intermédiaire est alors inversée d'une façon indésirable. Afin de rétablir un déphasage correct du signal de sortie, il a donc été prévu un second étage amplificateur qui fonctionne en alternance avec le premier étage amplificateur avec la même période que les étages d'acquisition.

Comme il est montré sur la figure 2, sur le front montant de l'horloge H, l'état attendu pour le signal intermédiaire $\overline{V_M}$ est inversé. Mais le second étage amplificateur étant en même temps mis en fonctionnement, le signal de sortie $\overline{S}$ présente néammoins la phase attendue, appropriée à suivre le signe de la différence entre les signaux d'entrée.

La forme des signaux qui seraient obtenus s'il n'y avait qu'un seul étage d'acquisition et amplificateur, et si le second signal d'horloge n'intervenait pas est donnée en pointillé. La forme des signaux obtenus dans le circuit selon l'invention est donnée en trait plein.

Dans un exemple de réalisation le comparateur selon l'invention peut donc avantageusement être constitué de transistors à effet de champ à désertion de charges, en arséniure de gallium, bien que ceux-ci présentent un effet d'hystérésis.

On rappelle que cet effet est lié à un effet mémoire des transistors constituant l'étage d'acquisition dû aux charges stockées dans les niveaux pièges de l'arséniure de gallium. Cet effet est d'autant plus important que le temps séparant deux montées et descentes successives de la tension d'entrée est faible devant la constante de temps des pièges.

Or l'arséniure de gallium du fait de sa haute mobilité électronique permet par ailleurs de réaliser des circuits ultra-rapides. La présente invention permet de ne pas perdre le bénéfice de cette dernière propriété.

En effet la présence des deux étages d'acquisition permet de permuter de façon cyclique la tension à coder et la tension de référence et ceci à une fréquence grande devant la constante de temps des pièges. Dans ces conditions les pièges se chargent à un niveau neutre et l'effet d'hystérésis est annulé.

Dans l'exemple de réalisation de l'invention décrit ici, le comparateur est donc constitué de transistors à effet de champ à grille Schottky, à désertion de charges, c'est-à-dire dont la tension de pincement $V_T < 0$, entraîne qu'ils sont normalement passant en l'absence de signal.

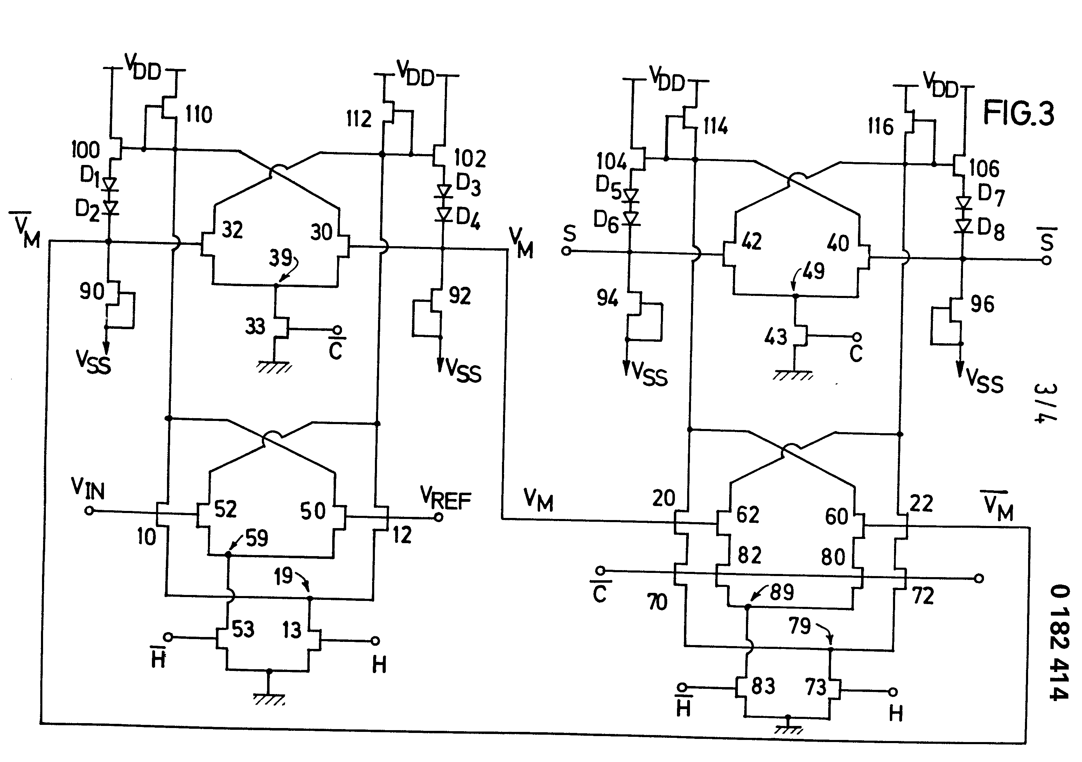

Tel que représenté sur la figure 3, le premier étage d'acquisition est formé de deux transistors 10 et 12, couplés par les sources et dont les grilles reçoivent respectivement la tension d'entrée analogique $V_{IN}$ et la tension de référence analogique $V_{REF}$. Les sources couplées au point de connexion 19 sont mises par exemple à la masse par l'intermédiaire d'un transistor source de courant 13 commandé par l'horloge H.

Le second étage d'acquisition est formé de deux transistors 52 et 50 couplés par leurs sources et dont les grilles reçoivent respectivement la tension d'entrée $V_{IN}$ et la tension de référence $V_{REF}$. Les sources couplées au point de connexion 59 sont mises à la masse par l'intermédiaire d'un transistor source de courant 53 commandé par le complémentaire $\overline{H}$ du signal d'horloge H. Les drains respectifs des transistors 52 et 50 sont couplés en croix aux drains des transistors 10 et 12.

Les drains des transistors 10 et 50 sont portés à une première tension d'alimentation continue $V_{DD}$ par l'intermédiaire d'un transistor de charge 110, et les drains des transistors 52 et 12 sont portés à la tension d'alimentation $V_{DD}$ par l'intermédiaire d'un transistor de charge 112.

Le premier étage mémoire est formé de deux transistors 32 et 30 couplés par leurs sources au point de connexion 39. Ce point de connexion est porté au potentiel de la masse par l'intermédiaire d'un transistor source de courant 33 commandé par le signal d'horloge complémentaire $\overline{C}$. Les drains des transistors 30 et 32 sont couplés en croix respectivement aux drains des transistors des étages d'acquisition, et fournissent les signaux intermédiaires $\overline{V_M}$ et $V_M$.

Le premier étage amplificateur est formé de deux transistors 20 et 22 dont les sources sont mises au même potentiel par l'intermédiaire des transistors respectifs 70 et 72 commandés par le signal d'horloge complémentaire $\overline{C}$. Les grilles des transistors 20 et 22 reçoivent respectivement le signal intermédiaire $\overline{V_M}$ et son complémentaire $V_M$. Les transistors 70 et 72, qui jouent le rôle d'interrupteur sont couplés par leurs sources au point de connexion 79. Ce point de connexion est mis à la masse par l'intermédiaire d'un transistor source de courant 73 commandé par le signal d'horloge H.

Le second étage amplificateur est formé de deux transistors 62 et 60 dont les sources sont mises au même potentiel par l'intermédiaire des transistors respectifs 82 et 80 commandés par le signal d'horloge complémentaire $\overline{C}$. Les grilles des transistors 62 et 60 reçoivent respectivement le signal intermédiaire $V_M$ et son complémentaire $\overline{V_M}$. Les transistors 82 et 80, qui jouent le rôle d'interrupteurs sont couplés par leurs sources au point de connexion 89. Ce point de connexion est mis à la masse par l'intermédiaire d'un transistor source de courant 83 commandé par le signal d'horloge complémentaire $\overline{H}$.

Les drains des transistors 60 et 62 sont couplés en croix aux drains des transistors 20 et 22. Les couples de transistors interrupteurs 70 et 72 d'une part et 80 et 82 d'autre part, aurait pu être remplacés chacun par un transistor unique. Mais s'il en était ainsi, les couples de transistors 20 et 22 d'une part, et 62 et 60 d'autre part présenteraient sur leurs sources un point de connexion qui constituerait un chemin possible pour le passage du courant dans le cas où $\overline{C}$ est à l'état bas. Or les signaux traités dans cette partie du circuit ont déjà une forme logique et présentent donc une amplitude suffisamment grande pour se propager par un tel chemin, ce qui est indésirable.

Le second étage mémoire est formé de deux transistors 42 et 40 couplés par leurs sources au point de connexion 49. Ce point de connexion est porté au potentiel de la masse par l'intermédiaire d'un transistor source de courant 43 commandé par le signal d'horloge C. Les drains des transistor 40 et 42 sont couplés en croix respectivement aux drains des transistors des étages amplificateurs, et fournissent les signaux de sortie du comparateur S et $\overline{S}$.

Du fait que les transistors utilisés dans ce circuit sont du genre à désertion de charge, c'est-à-dire des transistors admettant une tension de seuil $V_T < 0$, le signal de sortie du comparateur ne convient pas a priori à être amené à un circuit logique. Pour obtenir le niveau de tension requis, il est nécessaire d'utiliser un circuit de décalage de niveau. Un tel circuit de décalage de niveau est appelé logique BFL (Buffered Fet Logic). Il est constitué par un premier transistor suiveur, qui est monté en drain commun et dont l'électrode de commande est connectée à la sortie de l'étage mémoire. L'électrode de source de ce transistor suiveur est connectée, suivant le décalage de niveau requis, par l'intermédiaire de 1 à 3 diode(s) au drain d'un transistor monté comme source de courant. Le drain de ce transistor de source de courant constitue la sortie du circuit. Les drains des transistors 30 et 32 sont donc connectés, par l'intermédiaire des électrodes de commande du transistor suiveur d'un circuit de décalage de niveau. Ce circuit de décalage de niveau pour le transistor 30 est formé par le transistor suiveur 100, deux diodes $D_1$ et $D_2$ et le transistor monté comme source de courant 90 et pour le transistor 32 par le transistor suiveur 102, les diodes $D_3$ et $D_4$ et le transistor monté comme source de courant 92. Le signal intermédiaire $V_M$ et son complémentaire $\overline{V_M}$ se trouvent donc respectivement au drain du transistor 92 et au drain du transistor 90 de ces circuits de décalage de niveau.

De même, les drains des transistors 40 et 42 sont connectés, par l'intermédiaire des électrodes de commande et de source court-circuitées des transistors 114 et 116, à l'électrode de commande du transistor suiveur d'un circuit de décalage de niveau. Ce circuit de décalage de niveau pour le transistor 40 est formé par le transistor suiveur 104, deux diodes $D_5$ et $D_6$ et le transistor monté comme source de courant 94 et pour le transistor 42 par le transistor suiveur 106, les diodes $D_7$ et $D_8$ et le transistor monté comme source de courant 96. Le signal de sortie S et le signal de sortie complémentaire $\overline{S}$ du comparateur se trouvent donc respectivement au drain du transistor 94 et au drain du transistor 96 de ces circuits de décalage de niveau.

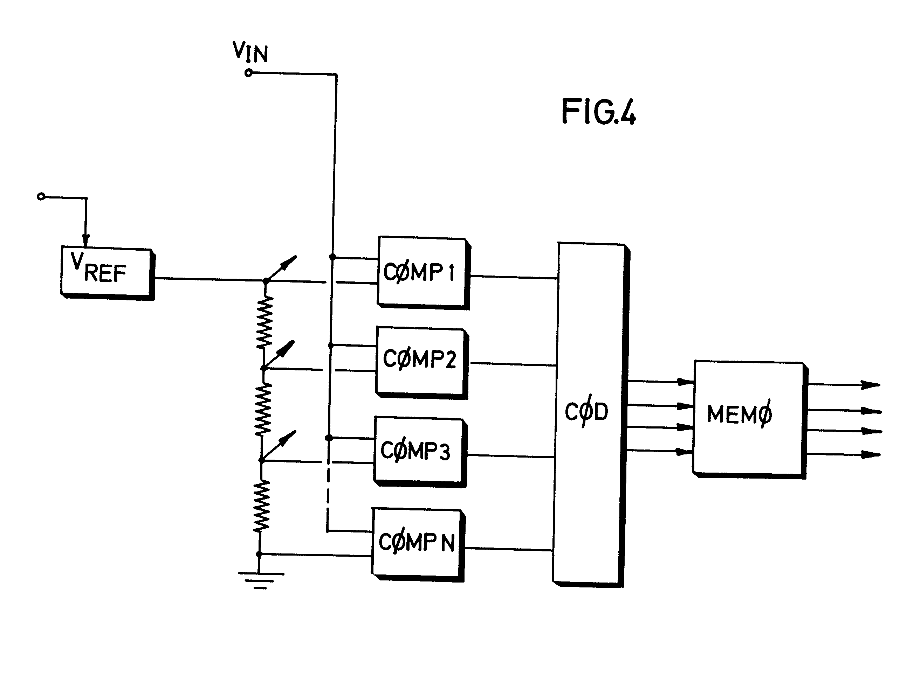

Le convertisseur analogique-numérique représenté sur la figure 4 comporte plusieurs comparateurs montés en parallèle (COMP 1,... COMPN,) qui sont munis chacun de deux entrées. La tension d'entrée analogique $V_{IN}$ à convertir est amenée à une entrée de chaque comparateur. A l'autre entrée de chaque comparateur est amenée une tension de référence obtenue par application d'une tension de référence aux bornes du montage en série de plusieurs résistances. Dans le cas où toutes les résistances sont égales, on obtient une progression géométrique des tensions de référence, le rapport relatif des tensions de référence étant égal à $V_{REF}/2$. Les diverses tensions de référence présentant un numéro de rang 1, 2,..., i, $2^{n-1}, 2^n$ constituent alors une série suivante $V_{REF}/2^n$, $V_{REF}/2^{n-i}$, ... $V_{REF}n$ ces dernières tensions n'étant utilisées que pour indiquer un bit de dépassement. Les sorties des comparateurs sont connectées aux entrées d'un dispositif de codage logique (COD), qui délivre un signal numérique de n bits à la sortie suivant un code quelconque, qui peut être par exemple le code de Gray. La structure du dispositif de codage est tributaire du code requis, mais n'est pas ici décrite en détail, du fait que ce dispositif de codage ne fait pas, à proprement dit, partie de l'invention. Une mémoire (MEMO) peut être couplée à la sortie du dispositif de codage pour conserver l'information du dispositif de codage pendant au moins une partie de la période d'horloge permettant la synchronisation des comparateurs. Le signal d'horloge nécessaire pour le comparateur et les mémoires est délivré par un circuit externe.

Ces circuits peuvent être intégrés sur le même substrat semiconducteur.

Dans l'exemple de réalisation décrit, les tensions $V_{IN}$, $V_{REF}$, $V_M$, $\overline{V_M}$, S et $\overline{S}$ sont de 0V pour le niveau haut et -2V pour le niveau bas.

Les tensions de seuil des transistors sont $V_T = -2V$.

Les tensions d'alimentation continues sont :

pour la première $V_{DD} = +4V$

pour la seconde, la masse = 0V

pour la troisième $V_{SS} = -3V$ à laquelle sont portées les sources des transistors sources de courant des étages décaleurs de niveau.

Les transistors et les diodes sont du type Schottky dont les largeurs de grilles sont rassemblées dans le tableau I suivant :

## TABLEAU I

| | L = 15 μm | L = 10 μm |
|---|---|---|
| Transistors N° | 13, 53, 33<br>83, 73, 43<br>10, 12, 50, 52<br>70, 72, 80, 82<br>20, 22, 60, 62<br>30, 32, 40, 42 | 110, 112, 114, 116<br>100, 102, 104, 106<br>90, 92, 94, 96<br>$D_1$, $D_2$, $D_3$, $D_4$<br>$D_5$, $D_6$, $D_7$, $D_8$ |

L'utilisation d'un comparateur identique pour la réalisation d'un convertisseur analogique-numérique signifie également un avantage pour la réalisation sous forme d'un circuit intégré.

Il est évident pour l'homme de l'art que de nombreuses variantes peuvent être réalisées sans sortir du cadre de la présente invention comme défini dans les revendications ci-annexées.

REVENDICATIONS :

1.　　　　　　Comparateur de tensions synchronisé, réalisé à l'aide de transistors dotés chacun d'une borne de commande, d'une première borne principale et d'une seconde borne principale, ce comparateur comprenant :

　　　　　- un étage d'acquisition servant à comparer une tension d'entrée analogique $V_{IN}$ à une tension de référence analogique $V_{REF}$ et à fournir le résultat de la comparaison sous forme d'un signal intermédiaire $V_M$ et son complémentair $\overline{V_M}$, cet étage incluant deux transistors (10 et 12) formant une première paire différentielle, la tension d'entrée $V_{IN}$ et la tension de référence $V_{REF}$ étant appliquées respectivement sur les bornes de commande de ces transistors dont les premières bornes principales présentent un point de connexion (19) servant à amener un courant de réglage, et dont les secondes bornes principales sont couplées chacune par l'intermédiaire d'une charge (110,112) à une première borne d'alimentation continue $V_{DD}$ et fournissent respectivement le signal intermédiaire $V_M$ et son complémentaire $\overline{V_M}$ ;

　　　　　- un étage amplificateur servant à amplifier les états logiques du signal intermédiaire, cet étage incluant deu transistors (20,22) formant une deuxième paire différentielle, ledit signal intermédiaire $V_M$ et son complémentaire $\overline{V_M}$ étant appliqués respectivement sur les bornes de commande de ces transistors dont les premières bornes principales servent à amener un courant de réglage et dont les secondes bornes principales sont couplées chacune par l'intermédiaire d'une charge (114,116) à la première borne d'alimentation continue $V_{DD}$ et fournissent le signal numérique de sortie S du comparateur, et son complémentaire $\overline{S}$ ;

　　　　　- un premier et un second étage mémoire couplés respectivement à l'étage d'acquisition et à l'étage amplificateur, servant à produire et à retenir les états logiques déterminés par les signaux issus des étages d'acquisition et amplificateur, le premier de ces étages mémoires incluant deux transistors (30 et 32) formant une troisième paire différentielle monté en bascule bistable, le signal intermédiaire $V_M$
et son complémentaire $\overline{V_M}$ étant appliqués respectivement sur
les bornes de commande de ces transistors dont les premières
bornes principales présentent un point de connexion (39) servant à amener un courant de réglage et dont les secondes bornes principales sont couplées en croix aux secondes bornes
principales des transistors de l'étage d'acquisition, le second de ces étages mémoires incluant deux transistors (40 et
42) formant une quatrième paire différentielle montée en bascule bistable, le signal numérique S issu de l'étage amplificateur et son complémentaire $\overline{S}$ étant appliqués respectivement
sur les bornes de commande de ces transistors, dont les premières bornes principales présentent un point de connexion
(49) servant à amener un courant de réglage et dont les secondes bornes principales sont couplées en croix aux secondes
bornes principales des transistors de l'étage amplificateur,
ce comparateur étant caractérisé en ce qu'il comprend en
outre :

        - un second étage d'acquisition servant à compenser l'hystérésis du premier étage d'acquisition, ce second
étage d'acquisition incluant deux transistors (52 et 50) formant une cinquième paire différentielle, la tension d'entrée
et la tension de référence étant appliquées respectivement sur
les bornes de commande de ces transistors dont les premières
bornes principales présentent un point de connexion (59) servant à amener un courant de réglage et dont les secondes bornes principales sont couplées en croix aux secondes bornes
principales des transistors du premier étage d'acquisition.

        - un second étage amplificateur servant à lever
l'indétermination sur la phase des états logiques du signal
intermédiaire, ce second étage amplificateur incluant deux
transistors (62 et 60) formant une sixième paire différentielle, ledit signal intermédiaire et son complémentaire étant
appliqués respectivement sur les bornes de commande de ces transistors, dont les premières bornes principales servent à amener un courant de réglage et dont les secondes bornes principales sont couplées en croix aux secondes bornes principales des transistors du premier étage amplificateur,

et caractérisé en ce que les courant de réglage de la première et de la cinquième paire différentielle sont tels que le premier et le second étage d'acquisition travaillent alternativement, en ce que les courants de réglage de la deuxième et de la sixième paire différentielle sont tels que le premier et le second étage amplificateur travaillent alternativement, en ce que les courants de réglage de la troisième et de la quatrième paire différentielle sont tels que le premier et le second étage mémoire travaillent alternativement, et en ce que les courant de réglage des étages amplificateurs sont tels qu'ils travaillent en phase avec les étages d'acquisition et avec le premier étage mémoire.

2. Comparateur selon la revendication 1, caractérisé en ce que les courants de réglage des différents étages sont fournis d'une façon appropriée du fait que :

- le point de connexion (49) de la quatrième paire différentielle est couplé à une deuxième borne d'alimentation continue, par exemple la masse, par l'intermédiaire d'un transistor source de courant (43) commandé par un premier signal d'horloge C, et en ce que le point de connexion (39) de la troisième paire différentielle est couplé à la deuxième borne d'alimentation continue par l'intermédiaire d'un transistor source de courant (33) commandé par le complémentaire C du premier signal d'horloge, en sorte que le premier et le second étage mémoire sont mis en fonctionnement alternativement.

- le point de connexion (19) de la première paire différentielle est couplé à la deuxième borne d'alimentation continue par l'intermédiaire d'un transistor source de courant (13) commandé par un second signal d'horloge H et en ce que le point de connexion (59) de la cinquième paire différentielle est couplé à la deuxième borne d'alimentation continue par l'intermédiaire d'un transistor source de courant (53) commandé par le signal complémentaire $\overline{H}$ du second signal d'horloge, en sorte que le premier et le second étage d'acquisition sont mis en fonctionnement alternativement.

- les premières bornes principales des deux transistors (20, 22) de la deuxième paire différentielle sont couplées respectivement aux secondes bornes principales de deux transistors (70,72) montés en septième paire différentielle dont les bornes de commande reçoivent le signal complémentaire $\overline{C}$ du premier signal d'horloge et dont les premières bornes principales présentent un point de connexion (79) couplé à la deuxième borne d'alimentation continue par l'intermédiaire d'un transistor source de courant (73) commandé par le signal d'horloge H.

- les premières bornes principales des deux transistors (62,60) de la sixième paire différentielle sont couplées respectivement aux secondes bornes principales de deux transistors (82,80) montés comme huitième paire différentielle, dont les bornes de commande reçoivent le signal complémentaire $\overline{C}$ du premier signal d'horloge et dont les premières bornes principales présentent un point de connexion (89) couplé à la seconde borne d'alimentation continue par l'intermédiaire d'un transistor source de courant (83) commandé par le complémentaire $\overline{H}$ du second signal d'horloge, en sorte que le premier et le second étage amplificateur sont mis en fonctionnement alternativement, et en phase avec d'une part les étages d'acquisition et d'autre part le premier étage mémoire.

3.　　　Comparateur selon la revendication 1 ou 2, caractérisé en ce que la charge des transistors des circuits d'acquisition et amplificateurs est formée par un transistor de charge présentant une borne de commande, une première borne principale et une seconde borne principale, la borne de commande étant connectée à la première borne principale, qui est couplée à la seconde borne principale des transistors correspondants des paires différentielles des circuits d'acquisition et amplificateurs, et la seconde borne principale étant reliée à la première borne d'alimentation continue.

4. Comparateur selon la revendication 3, caractérisé en ce que chaque charge comporte en outre un circuit de décalage de niveau, qui est formé par un transistor présentant une borne de commande, une première borne principale et une deuxième borne principale, la borne de commande étant couplée à la borne de commande du transistor de charge, la deuxième borne principale étant couplée à la première borne d'alimentation et la première borne principale étant couplée, par l'intermédiaire du montage en série de plusieurs diodes de décalage de niveau à la sortie et à une source de courant.

5. Comparateur selon la revendication 4, caractérisé en ce que la source de courant est constituée par un transistor présentant une borne de commande, une première borne principale et une deuxième borne principale, la borne de commande et la première borne principale étant connectées à une borne d'alimentation continue $V_{SS}$.

6. Comparateur selon l'une des revendications précédentes, caractérisé en ce que les transistors du circuit sont des transistors à effet de champ du genre Schottky et notamment de tels transistors du genre à désertion de charge.

7. Convertisseur analogique numérique, caractérisé en ce que pour obtenir un signal de sortie numérique à n bits, le convertisseur analogique numérique est muni de $2^n$ comparateurs synchronisés montés en parallèle selon l'une des revendications précédentes, et en ce que à une entrée de chaque comparateur est amené le signal d'entrée analogique à convertir et à l'autre entrée de chaque comparateur une tension de référence différente, les sorties de comparateurs étant connectées à un dispositif de codage, dont la sortie délivre le signal de sortie numérique à n bits.

FIG.1

FIG. 2

2/4

0 182 414

2 -IV- PHF 84 - 597

0 182 414

FIG.3

FIG.4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| | | | H 03 K 3/356 |
| A | IEEE TRANSACTIONS ON ELECTRON DEVICES, vol. ED-29, no. 7, juillet 1982, pages 1094-1102, IEEE, New York, US; C.A. LIECHTI et al.: "A GaAs MSI word generator operating at 5 Gbits/s data rate" * Page 1096, colonne de gauche, dernier alinéa - page 1097, colonne de gauche, premier alinéa; figure 3 * | 1-6 | |
| A | EP-A-0 084 844 (MATSUSHITA) * Page 10, ligne 17 - page 15, ligne 17; figures 8,9 * | 1,2,4, 6 | |
| A | IEEE TRANSACTIONS ON MICROWAVE THEORY AND TECHNIQUES, vol. MTT-32, no. 1, janvier 1984, pages 5-10, IEEE, New York, US; M. IDDA et al.: "Analysis of high-speed GaAs source-coupled FET logic circuits" * Page 9, figure 1 * | 1,2,4, 6 | DOMAINES TECHNIQUES RECHERCHES (Int. Cl.4) H 03 K G 01 R |
| A | NUCLEAR INSTRUMENTS AND METHODS, vol. 116, no. 3, 15 avril 1974, page 611, North-Holland Publishing Co., Amsterdam, NL; P. GHELFAN: "Tunnel-diode comparator with controlled hysteresis" * En entier * | 1 | |

Le présent rapport de recherche a été établi pour toutes les revendications

| Lieu de la recherche | Date d'achèvement de la recherche | Examinateur |
|---|---|---|
| LA HAYE | 17-02-1986 | CANTARELLI R.J.H. |